# EUROPEAN PATENT SPECIFICATION

(11) **EP 3 902 011 B1**
(45) Date of publication and mention of the grant of the patent: **04.11.2026**
(21) Application number: 19903618.7
(22) Date of filing: 05.09.2019
(51) Int. Cl.: H10D 18/60, H10D 62/17, H10D 62/53, H10D 64/27, H03K 17/567

(54) **COMPONENT HAVING REVERSE FLOW FUNCTION**
BAUTEIL MIT UMKEHRSTROMFUNKTION
COMPOSANT AYANT UNE FONCTION DE FLUX INVERSE

(30) Priority: 27.12.2018 CN 201811613543
(43) Date of publication of application: 27.10.2021
(73) Proprietor: Tsinghua University, Beijing 100084 (CN)
(72) Inventor: ZENG, Rong, Beijing 100084 (CN); LIU, Jiapeng, Beijing 100084 (CN); ZHOU, Wenpeng, Beijing 100084 (CN); ZHAO, Biao, Beijing 100084 (CN); YU, Zhanqing, Beijing 100084 (CN); CHEN, Zhengyu, Beijing 100084 (CN)
(74) Representative: Meissner Bolte Partnerschaft mbB
(86) International application number: PCT/CN2019/104539
(87) International publication number: WO 2020/134177

(56) References cited:
- CN-A- 101 853 878
- CN-A- 101 853 878
- CN-A- 103 746 002
- CN-A- 105 226 057
- CN-A- 105 590 959
- CN-A- 109 686 783
- CN-B- 105 590 959
- CN-U- 201 577 025
- CN-U- 207 367 957
- US-A1- 2004 183 092
- US-A1- 2004 183 092
- US-A1- 2010 133 549

## Description

### FIELD OF TECHNOLOGY

The present invention relates to the technical field of power electronics, in particular to a device having a reverse conduction function.

### BACKGROUND

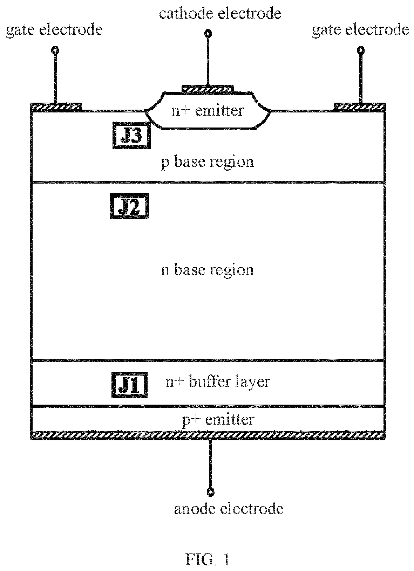

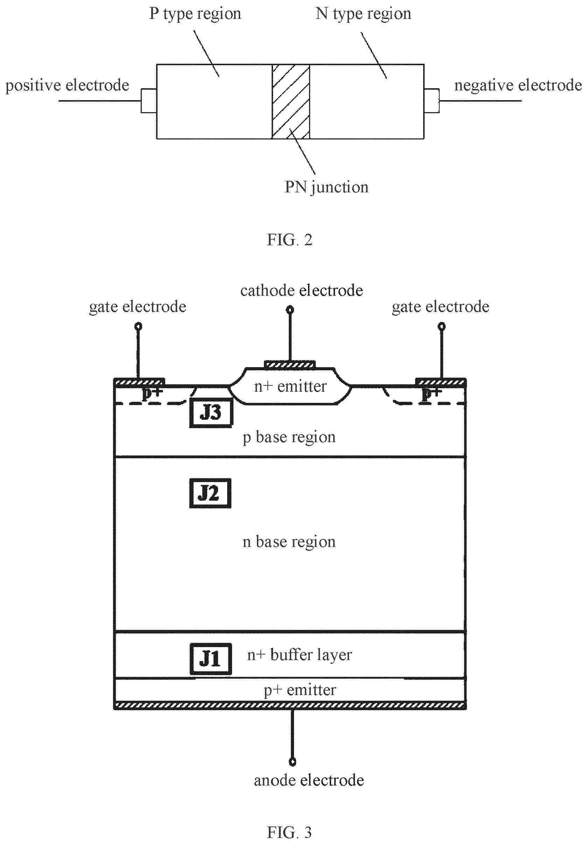

FIG. 1 shows a structural schematic diagram of a conventional GCT unit. As shown in the figure, an existing conventional GCT unit mainly includes two parts: a GCT chip and a corresponding compact gate driver, wherein the interior of the GCT chip has a typical asymmetric structure, and PN junctions are set inside the GCT chip. The PN junctions are formed by manufacturing a P type semiconductor and an N type semiconductor on the same semiconductor substrate by different doping process and the diffusion action, wherein the semiconductor substrate is generally silicon or germanium, and a space charge region called PN junction is formed on an interface between the P type semiconductor and the N type semiconductor. FIG. 2 shows a structural schematic diagram of the PN junction according to the prior art. The PN junction has unidirectional conductivity, which is a characteristic used by many devices in the electronic technology. The PN junction constitutes the material basis of semiconductor diodes and bipolar transistors. When a forward voltage is applied to the structure, a first PN junction J1 and a third PN junction J3 shown in FIG. 1 are forward biased and a second PN junction J2 is reverse biased. Due to the low resistivity level of the n base region, the structure can block several-kV voltage; however, when a reverse voltage is applied to the structure, the first PN junction J1 and the third PN junction J3 shown in FIG. 1 are reverse biased and the second PN junction J2 is forward biased. Due to the high doping concentration of the first PN junction J1 and the third PN junction J3, the blocking capability is only about 20 V. For the GCT chip with the conventional structure, due to the presence of a transparent anode electrode and a buffer layer structure, Zener breakdown or punch-through breakdown will occur in the first PN junction J1 under an extremely low reverse voltage. Therefore, when a reverse voltage is applied, the voltage mainly falls at the third PN junction J3; however, in the actual application situation, the GCT chip is used together with its gate driver, and the voltage distribution of the internal p base region or the n base region will be affected by the drive circuit. Under normal working conditions, the control logic of the conventional gate driver is as follows: in a blocking state, the electric potential of cathode electrode is set 20V higher than that of gate electrode, thereby ensuring that the device is in a stable blocking state; and in an on state, drive current is injected from the gate electrode to the cathode electrode to trigger the device to conduct. At this time, in the on state or the blocking state, it is liable to damage the drive circuit by applying a reverse voltage to the whole IGCT/ETO device.

In applications such as converters, power electronic devices generally need to have reverse conduction ability, which is usually implemented by an anti-paralleled diode outside the device or implementing the diode in a non-GCT region of the chip. However, antiparallel connection of the diode will introduce stray parameters in the loop to cause peak overvoltage and will increase the design difficulty of a press-fitting structure. Manufacturing the diode in the non-GCT region will reduce the current conducting capacity of the whole GCT chip and also will increase the difficulty of the process implementing process, which will greatly affect the yield.
CN 105 590 959 discloses a device according to the preamble of claim 1. Thyristor devices are also known from CN 201 577 025 U, CN 101 853 878 A, CN 207 367 957 U, US 2004/183092 A1 and US 2010/133549 A1.

### SUMMARY

For the technical problems in the prior art that reverse conduction is liable to damage devices and the yield of devices realizing reverse conduction function is low, the present invention provides a device having a reverse conduction function.

According to the invention, a device having a reverse conduction function includes: a GCT chip module and a drive circuit module, wherein the GCT chip module includes: a five-layer thyristor structure consisting of a p+ emitter , an n+ buffer layer, an n base region, a p base region and an n+ emitter , an anode electrode connected to the p+ emitter , a gate electrode connected to the p base region, and a cathode electrode connected to the n+ emitter ;
the p+ emitter and the n+ buffer layer are doped;
a highly-doped p+ region is formed below the gate electrode of the p base region;
the drive circuit module is connected to the cathode electrode and the gate electrode in the GCT chip module through cables;
the drive circuit module includes an IGCT drive circuit;
the IGCT drive circuit includes: a changeover switch, a direct-current power supply and a trigger current source. The IGCT drive circuit forms four circuits between the cathode electrode and the gate electrode of the GCT chip module through the changeover switch, the direct-current power supply and the trigger current source, wherein the four circuits include:
the cathode electrode directly connected to the gate electrode through the changeover switch;
the cathode electrode connected to a positive electrode of the direct-current power supply through the changeover switch and a negative electrode of the direct-current power supply connected to the gate electrode;
the cathode electrode connected to a negative electrode of the trigger current source through the changeover switch and a positive electrode of the trigger current power supply connected to the gate electrode; and
an open circuit formed through the changeover switch and the cathode electrode disconnected with the gate electrode.

Further, the anode electrode, the cathode electrode and the gate electrode of the GCT chip module may be all metal electrodes.

Further, the metal electrodes may have thickness of 5 um to 30 um.

The device provided by the present invention improves the characteristics of a GCT chip by doping an n+ buffer layer and a p+ emitter of a GCT chip module and by introducing a highly-doped p+ region below a gate electrode; and allows the GCT chip to be provided with a reverse conduction between a cathode electrode and the gate electrode by means of an IGCT drive circuit connected to the GCT chip module, thereby implementing a reverse conduction function of an IGCT device, and ensuring that the device is still provided with the performance of a conventional IGCT device during forward conduction. At the same time, without altering an existing GCT structure and affecting the normal functions of the IGCT device, the device provided by the present invention implements the reverse conduction of the IGCT device, the process steps are simple, and the yield of industrial production is increased. For application occasions such as converters, the complexity of system design can be obviously reduced, higher efficiency is realized by single power electronic device, and the overall reliability of equipment is improved. Other features and advantages of the present invention will be described in the following description, and some of these will become apparent from the description or be understood by implementing the present invention. The objectives and other advantages of the present invention can be implemented or obtained by structures indicated in the description, claims and accompanying drawings.

### BRIEF DESCRIPTION OF THE DRAWINGS

To describe the technical solutions in the embodiments of the present invention or in the prior art more clearly, the following briefly introduces the accompanying drawings required for describing the embodiments or the prior art. Apparently, the accompanying drawings in the following description show some embodiments of the present invention, and a person of ordinary skill in the art may still derive other drawings from these accompanying drawings without creative efforts.
FIG. 1 shows a structural schematic diagram of a conventional GCT unit according to the prior art;
FIG. 2 shows a structural schematic diagram of the PN junction according to the prior art;
FIG. 3 shows a schematic diagram of a p+ doped region below a gate electrode region of the GCT chip module forming part of a device having a reverse conduction function according to an embodiment of the present invention;
FIG. 4 shows a structural schematic diagram of an IGCT device having a reverse conduction function ; and
FIG. 5 shows a structural schematic diagram of an ETO device having a reverse conduction function according to an embodiment not forming part of the invention but useful for its understanding.

### DESCRIPTION OF THE EMBODIMENTS

In order to make the objectives, technical solutions and advantages of the embodiments of the present invention clearer, the technical solutions in the embodiments of the present invention are described below clearly and completely with reference to the accompanying drawings in the embodiments of the present invention. Apparently, the described embodiments are some rather than all of the embodiments. Based on the embodiments of the present invention, all the other embodiments obtained by those of ordinary skill in the art without creative effort are within the protection scope of the present invention.

The embodiment of the present invention provides a device having a reverse conduction function. The device includes a GCT chip module and a drive circuit module. The GCT chip module is provided with a five-layer thyristor structure consisting of a p+ emitter, an n+ buffer layer, an n base region, a p base region and an n+ emitter , an anode electrode connected to the p+ emitter , a gate electrode connected to the p base region, and a cathode electrode connected to the n+ emitter ; the GCT chip module has the same structure as the conventional GCT unit shown in FIG. 1; furthermore, in the GCT chip module, a first PN junction J1 is formed in a doping region consisting of the p+ emitter and the n+ buffer layer, a second PN junction J2 is formed in the n base region, and a third PN junction J3 is formed in the p base region. According to the embodiment of the present invention, the n+ buffer layer of the GCT chip module and the p+ emitter are doped, so that reversible and uniform avalanche breakdown or punch-through breakdown can occur in the first PN junction J1 under the condition of a reverse small voltage; furthermore, the GCT chip module is provided with a highly-doped p+ region below the gate electrode of the p base region, wherein the highly-doped p+ region specifically refers to a p+ doped region with concentration ranging from 10¹⁷/cm³ to 10²¹/cm³, so that not only the low resistance characteristic during reverse conduction is ensured, but also the breakdown characteristic of the third PN junction J3 is not affected, as shown in FIG. 3 which shows a schematic diagram of a p+ doped region below a gate electrode region of the GCT chip module forming part of a device having a reverse conduction function according to an embodiment of the present invention. The GCT chip module also needs to preform local life control processing so as to improve the dynamic characteristic of the GCT chip module. For example: a part of structure in the GCT chip is subjected to 1-12MeV electron irradiation or proton irradiation, and a proper recombination center is brought into the GCT chip, thereby reducing the minority carrier lifetime in the GCT chip. Meanwhile, the anode electrode, the cathode electrode and the gate electrode of the GCT chip module are all metal electrodes, wherein the metal electrodes are made of metal and have thickness of 5 um to 30 um, and the metal electrode structure can ensure that the GCT chip module has high lateral conduction capacity under the condition of large current.

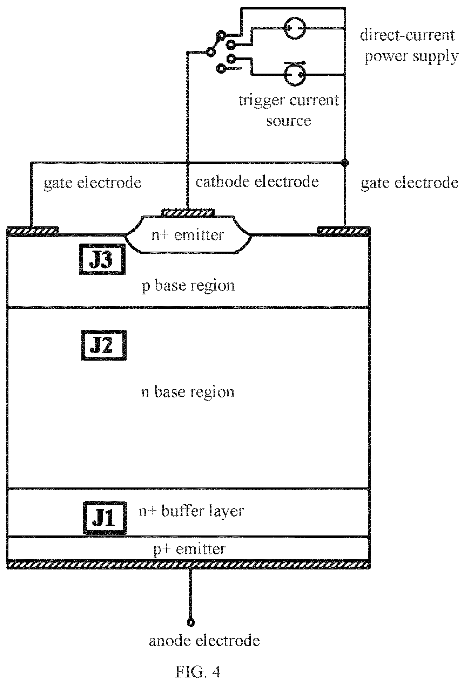

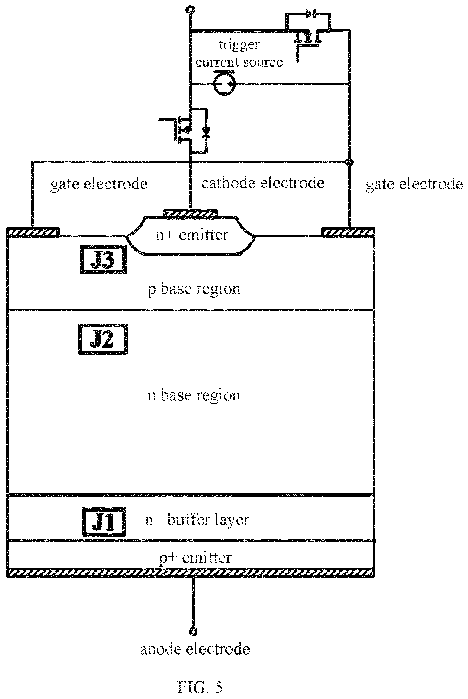

The drive circuit module is connected to the cathode electrode and the gate electrode in the GCT chip module through cables. The device provided by the embodiment of the present invention can form different circuits through the drive circuit module, so that the forward flow function of the device can be ensured, and the reverse conduction function of the device can be realized when the current direction is reversed. The drive circuit module includes an IGCT drive circuit in accordance with the invention or an ETO drive which is not claimed but which is useful for understanding the invention, wherein the IGCT drive circuit and the GCT chip module are connected to form an IGCT device having a reverse conduction function, and the ETO drive circuit and the GCT chip module are connected to form an ETO device having a reverse conduction function. FIG. 4 shows a structural schematic diagram of an IGCT device having a reverse conduction function. As shown in the figure, the GCT chip module of the IGCT device is connected to the IGCT drive circuit; the IGCT drive circuit includes a changeover switch, a direct-current power supply and a trigger current source; and the IGCT drive circuit forms four circuits between the cathode electrode and the gate electrode of the GCT chip module through the changeover switch, the direct-current power supply and the trigger current source. Further, through changeover of the changeover switch, the circuits which can be formed by the IGCT drive circuit include: 1. the cathode electrode and the gate electrode are directly connected to form short circuit; 2. the cathode electrode is connected to a positive electrode of the direct-current power supply, and a negative electrode of the direct-current power supply is connected to the gate electrode to form a forward flow path for injecting drive current from the gate electrode to the cathode electrode; 3. the cathode electrode is connected to a negative electrode of the trigger current source, and a positive electrode of the trigger current source is connected to the gate electrode to form a path; and 4.the cathode electrode and the gate electrode cannot connect with each other to form an open circuit. FIG. 5 shows a structural schematic diagram of an ETO device having a reverse conduction function. As shown in the figure, the GCT chip module of the ETO device is connected to an ETO drive circuit, and the ETO drive circuit includes a first low-voltage MOSFET, a second low-voltage MOSFET and a trigger current source. The ETO drive circuit forms two circuits between the cathode electrode and the gate electrode of the GCT chip module through the first low-voltage MOSFET, the second low-voltage MOSFET and the trigger current source. Further, the circuits which can be formed by the ETO drive circuit includes: 1. an emitter of the first low-voltage MOSFET is connected to the cathode electrode, a collector of the first low-voltage MOSFET is connected to a negative electrode of the trigger current source, and a positive electrode of the trigger current source and the gate electrode are connected to form a path; 2. the emitter of the first low-voltage MOSFET is connected to the cathode electrode, the collector of the first low-voltage MOSFET is connected to a collector of the second low-voltage MOSFET, and an emitter of the second low-voltage MOSFET is connected to the gate electrode, thereby forming a forward flow path for injecting drive current from the gate electrode to the cathode electrode or forming short circuit between the gate electrode and the cathode electrode in a short time.

In the circuits which can be formed by the above IGCT drive circuit or ETO drive circuit, for example: the IGCT device forms connection of the cathode electrode of the GCT chip module and the negative electrode of the trigger current source and connection of the positive electrode of the trigger current source and the gate electrode through the IGCT drive circuit so as to form a reverse conduction path for injecting the drive current from the cathode electrode to the gate electrode, or the ETO device forms connection of the cathode electrode of the GCT chip module and the emitter of the first low-voltage MOSFET and connection of the collector of the first low-voltage MOSFET and the negative electrode of the trigger current source and connection of the positive electrode of the trigger current source and the gate electrode through the ETO drive circuit so as to form a reverse conduction path for injecting the drive current from the cathode electrode to the gate electrode, the IGCT device or the ETO device has a reverse conduction function after the circuit having reverse flow is formed,.

The IGCT drive circuit or the ETO drive circuit can identify the current direction of the anode electrode. There are three main methods for identifying the current direction of the anode electrode, including: 1. comprehensive judgment is conducted by measuring a voltage between the gate electrode and the cathode electrode on a driver board and using the voltage and the internal trigger state of the driver; 2. an anode electrode current sensor is additionally mounted on the driver board for direct measurement; and 3. The voltage of the anode electrode and the cathode electrode is measured on the driver board, and the current direction of the anode electrode is measured and judged on the basis of the measured voltage. Under the abnormal condition of reverse conduction, the IGCT drive circuit or the ETO drive circuit also can short-circuit the gate electrode and the cathode electrode of the GCT chip in a short time, thereby ensuring that the device will not be damaged by abnormal conduction. Exemplarily, the IGCT drive circuit may form short circuit between the cathode electrode and the gate electrode of the GCT chip through the changeover switch; or the ETO drive circuit may form short circuit between the cathode electrode and the gate electrode of the GCT chip in a short time through the second low-voltage MOSFET. A low-resistance channel is formed between the gate electrode and the cathode electrode of the GCT chip by a method of forming short circuit. When a forward flow state is converted into a reverse conduction state, plasma in the GCT chip of the device participates in conduction to ensure normal work of the device. Specifically, for the IGCT drive circuit and the ETO drive circuit, when gate driver are powered off, the gate electrode and the cathode electrode should maintain short circuit state, for example: the ETO drive circuit may form short circuit between the cathode electrode and the gate electrode of the chip by connecting a power electronic device or a relay on the second low-voltage MOSFET in parallel so as to cope with the possible abnormal reverse conduction situation and prolong the service life of the device.

The device improves the characteristics of a GCT chip with doping in n+ buffer layer and a p+ emitter of a GCT chip module and by preparing a highly-doped p+ region below a gate electrode; and allows the GCT chip to conduct reversely between a cathode electrode and the gate electrode by means of an IGCT drive circuit as claimed, or an unclaimed ETO drive circuit connected to the GCT chip module, thereby implementing a reverse conduction function of an IGCT or ETO device, and ensuring that the device is still provided with the performance of a conventional IGCT or ETO device during forward conduction. At the same time, without altering an existing GCT structure and affecting the normal functions of the IGCT or ETO device, the device implements the reverse conduction to the IGCT or ETO device, the process steps are simple, and the yield of industrial production is increased. For application occasions such as converters, the complexity of system design can be obviously reduced, higher efficiency is realized by single power electronic device, and the overall reliability of equipment is improved.

## Claims

1. A device having a reverse conduction function, the device comprising: a GCT chip module and a drive circuit module, wherein the GCT chip module comprises: a five-layer thyristor structure consisting of a p+ emitter, an n+ buffer layer, an n base region, a p base region and an n+ emitter , an anode electrode connected to the p+ emitter, a gate electrode connected to the p base region, and a cathode electrode connected to the n+ emitter ; the p+ emitter and the n+ buffer layer are doped; a highly-doped p+ region is formed below the gate electrode of the p base region; a first PN junction (J1) is formed by the p+ emitter and the n+ buffer layer, a second PN junction (J2) is formed by the n base region and the p base region, a third PN junction (J3) is formed by the p base region and the n+ emitter;
**characterized in that** the drive circuit module is connected to the cathode electrode and the gate electrode in the GCT chip module through cables,
and that the drive circuit module includes an IGCT drive circuit, wherein the IGCT drive circuit comprises: a changeover switch, a direct-current power supply and a trigger current source; and the IGCT drive circuit forms four circuits between the cathode electrode and the gate electrode of the GCT chip module through the changeover switch, the direct-current power supply and the trigger current source, the four circuits comprising: the cathode electrode directly connected to the gate electrode through the changeover switch, the cathode electrode connected to a positive electrode of the direct-current power supply through the changeover switch and a negative electrode of the direct-current power supply connected to the gate electrode, the cathode electrode connected to a negative electrode of the trigger current source through the changeover switch and a positive electrode of the trigger current power supply connected to the gate electrode, and an open circuit formed through the changeover switch and the cathode electrode disconnected with the gate electrode.

2. The device according to claim 1, wherein the anode electrode, the cathode electrode and the gate electrode of the GCT chip module are all metal electrodes.

3. The device according to claim 2, wherein the metal electrodes have thickness of 5 um to 30 um.

## Patentansprüche

1. Vorrichtung mit einer Rückwärtsleitungsfunktion, wobei die Vorrichtung Folgendes umfasst: ein GCT-Chipmodul und ein Ansteuerschaltungsmodul, wobei das GCT-Chipmodul Folgendes umfasst: eine fünfschichtige Thyristorstruktur, bestehend aus einem p+-Emitter, einer n+-Pufferschicht, einem n-Basisbereich, einem p-Basisbereich und einem n+-Emitter, einer mit dem p+-Emitter verbundenen Anodenelektrode, einer mit dem p-Basisbereich verbundenen Gate-Elektrode und einer mit dem n+-Emitter verbundenen Kathodenelektrode, wobei der p+-Emitter und die n+-Pufferschicht dotiert sind, wobei unterhalb der Gate-Elektrode des p-Basisbereichs ein hochdotierter p+-Bereich ausgebildet ist, wobei ein erster PN-Übergang (J1) durch den p+-Emitter und die n+-Pufferschicht gebildet wird, wobei ein zweiter PN-Übergang (J2) durch den n-Basisbereich und den p-Basisbereich gebildet wird, wobei ein dritter PN-Übergang (J3) durch den p-Basisbereich und den n+-Emitter gebildet wird,
**dadurch gekennzeichnet, dass** das Ansteuerschaltungsmodul über Kabel mit der Kathodenelektrode und der Gate-Elektrode im GCT-Chipmodul verbunden ist,
und dass das Ansteuerschaltungsmodul eine IGCT-Ansteuerschaltung umfasst, wobei die IGCT-Ansteuerschaltung Folgendes umfasst: einen Umschalter, eine Gleichstromversorgung und eine Triggerstromquelle, wobei die IGCT-Ansteuerschaltung über den Umschalter, die Gleichstromversorgung und die Triggerstromquelle vier Schaltungen zwischen der Kathodenelektrode und der Gate-Elektrode des GCT-Chipmoduls bildet, wobei die vier Schaltungen Folgendes umfassen: die Kathodenelektrode, die über den Umschalter direkt mit der Gate-Elektrode verbunden ist, die Kathodenelektrode, die über den Umschalter mit einer positiven Elektrode der Gleichstromversorgung verbunden ist, und eine negative Elektrode der Gleichstromversorgung, die mit der Gate-Elektrode verbunden ist, die Kathodenelektrode, die über den Umschalter mit einer negativen Elektrode der Triggerstromquelle verbunden ist, und eine positive Elektrode der Triggerstromquelle, die mit der Gate-Elektrode verbunden ist, sowie eine offene Schaltung, die über den Umschalter gebildet wird und bei der die Kathodenelektrode von der Gate-Elektrode getrennt ist.

2. Vorrichtung nach Anspruch 1, wobei die Anodenelektrode, die Kathodenelektrode und die Gate-Elektrode des GCT-Chipmoduls alle Metallelektroden sind.

3. Vorrichtung nach Anspruch 2, wobei die Metallelektroden eine Dicke von 5 µm bis 30 µm aufweisen.

## Revendications

1. Dispositif ayant une fonction de conduction inverse, le dispositif comprenant : un module de puce GCT et un module de circuit d'attaque, dans lequel le module de puce GCT comprend : une structure de thyristor à cinq couches constituée d'un émetteur p+, d'une couche tampon n+, d'une région de base n, d'une région de base p et d'un émetteur n+, ainsi qu'une électrode d'anode connectée à l'émetteur p+, une électrode de grille connectée à la région de base p, et une électrode de cathode connectée à l'émetteur n+ ; l'émetteur p+ et la couche tampon n+ sont dopés ; une région p+ fortement dopée est formée au-dessous de l'électrode de grille de la région de base p ; une première jonction PN (J1) est formée par l'émetteur p+ et la couche tampon n+, une deuxième jonction PN (J2) est formée par la région de base n et la région de base p, une troisième jonction PN (J3) est formée par la région de base p et l'émetteur n+ ;
**caractérisé en ce que** le module de circuit d'attaque est connecté à l'électrode de cathode et à l'électrode de grille du module de puce GCT par des câbles,
et **en ce que** le module de circuit d'attaque comporte un circuit d'attaque IGCT, dans lequel le circuit d'attaque IGCT comprend : un commutateur, une alimentation électrique en courant continu et une source de courant de déclenchement ; et le circuit d'attaque IGCT forme quatre circuits entre l'électrode de cathode et l'électrode de grille du module de puce GCT par l'intermédiaire du commutateur, de l'alimentation électrique en courant continu et de la source de courant de déclenchement, les quatre circuits comprenant : l'électrode de cathode directement connectée à l'électrode de grille par l'intermédiaire du commutateur, l'électrode de cathode connectée à une électrode positive de l'alimentation électrique en courant continu par l'intermédiaire du commutateur et une électrode négative de l'alimentation électrique en courant continu connectée à l'électrode de grille, l'électrode de cathode connectée à une électrode négative de la source de courant de déclenchement par l'intermédiaire du commutateur et une électrode positive de la source de courant de déclenchement connectée à l'électrode de grille, et un circuit ouvert formé par l'intermédiaire du commutateur, et l'électrode de cathode étant déconnectée de l'électrode de grille.

2. Dispositif selon la revendication 1, dans lequel l'électrode d'anode, l'électrode de cathode et l'électrode de grille du module de puce GCT sont toutes des électrodes métalliques.

3. Dispositif selon la revendication 2, dans lequel les électrodes métalliques ont une épaisseur de 5 µm à 30 µm.
